(19) Europäisches Patentamt
European Patent Office
Office européen des brevets

(11) **EP 2 704 327 A1**

(12) **EUROPEAN PATENT APPLICATION**

(43) Date of publication:
**05.03.2014 Bulletin 2014/10**

(51) Int Cl.:
**H03K 17/95** (2006.01)    **G01D 11/24** (2006.01)

(21) Application number: **12182879.2**

(22) Date of filing: **04.09.2012**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **Optosys SA
1762 Givisiez (CH)**

(72) Inventor: **Heimlicher, Peter
CH-1700 Fribourg (CH)**

(74) Representative: **AMMANN PATENTANWÄLTE AG
BERN
Schwarztorstrasse 31
Postfach 5135
3001 Bern (CH)**

(54) **Method of manufacturing an inductive proximity switch**

(57) The invention relates to a method of manufacturing an inductive proximity switch, in which an enclosure (2) is formed from a single piece (16) of a non-ferromagnetic metal and electronic components (3, 4, 5, 6, 7) are inserted into the enclosure (2), and to a corresponding proximity switch. The electronic components comprise a coil (3) configured to be supplied with transmitting current pulses and a processing circuit (4) configured to generate an output signal based on received voltages induced in the coil (3) after the duration of the transmitting current pulses.

In order to fabricate a proximity switch with an improved robustness by maintaining its proper functionality, the invention suggests that forming of the enclosure (2) comprises the step of deep drawing a sheet (16) of the non-ferromagnetic metal to a tubular element (2, 17, 23, 25) with a front wall (11, 19) covering its front end and a side wall (15, 20) delimiting an inner space for receiving the electronic components (3, 4, 5, 6, 7).

# FIG. 1

**Description**

The present invention relates to a method of manufacturing an inductive proximity switch, in which an enclosure is formed from a single piece of a non-ferromagnetic metal and electronic components are inserted into the enclosure. The electronic components comprise a coil configured to be supplied with transmitting current pulses at a period larger than the duration of the transmitting current pulses and a processing circuit configured to generate an output signal based on received voltages induced in the coil after the duration of the transmitting current pulses. The invention also relates to an inductive proximity switch of a generic kind.

An inductive proximity switch of that kind is known from EP 0 936 739 A1 and EP 0 936 741 A1 to the applicant of the present invention. Based on a variation of the voltages induced in the coil after the duration of the transmitting current pulses, a change of position of an object in the proximity of the switch can be detected. It has been found that a fabrication of the enclosure from a non-ferromagnetic material is of vital importance for the proper functioning of the switch. With such a material, a generation of eddy currents in the enclosure walls after the duration of the transmitting current pulses can be kept sufficiently low, allowing accurate object detection. To achieve a desired robustness of the device, a metallic material of the enclosure is preferred.

Fabricating the enclosure from a single piece has the purpose to avoid any possible sources of leakage between different material interfaces in order to provide excellent water tightness properties. In addition, a high degree of precision of its wall dimensions should be met during fabrication of the enclosure, in particular at the active area through which the magnetic field is transmitted, to allow a reliable operation of the electronic components which are calibrated with respect to a predetermined thickness of the non-ferromagnetic material.

A technique of fabricating an enclosure with the required precision involves a solid work piece of a non-ferromagnetic metal, such as a metal rod. A cutting tool is applied on the rear end and advanced towards the interior of the metal rod to hollow out the enclosure cavity. Current cutting techniques allow controlling the wall thickness of the enclosure within the desired precision interval.

Some applications of the proximity switch require an enclosure with reduced dimensions. The demand for such an enclosure is particularly driven by an ongoing miniaturization trend in the microelectronics industry producing on the one hand smaller electronic components and thus a smaller volume required for the components to be included in the enclosure, and yielding on the other hand new application areas for a proximity switch with a smaller size.

Reducing the wall dimensions of the enclosure, however, has a negative impact on its robustness. Yet it is highly desirable to maintain a certain mechanical strength of the proximity switch, even when the size of the enclosure walls is reduced in the course of a device miniaturization.

It is therefore an object of the present invention to provide a fabrication method for a proximity switch of the kind mentioned in the introduction and a corresponding proximity switch so as to ensure its proper functionality by simultaneously improving its robustness. It is another object of the invention to provide an enclosure with an improved robustness without the need to adapt the internal electronic components to a modified environment. It is a further object of the invention to maintain a certain mechanical strength of a proximity switch with reduced dimensions.

At least one of these objects is attained by the manufacturing method according to claim 1 and the inductive proximity switch according to claim 10. The dependent claims define preferred embodiments.

Thus, in a method according to the invention, forming of the enclosure comprises the step of deep drawing a sheet of the non-ferromagnetic metal to a tubular element with a front wall covering its front end and a side wall delimiting an inner space for receiving the electronic components. A corresponding proximity switch according to the invention comprises an enclosure consisting of such a tubular element.

It was found in the context of the present invention that the tubular element obtained by deep drawing of a non-ferromagnetic metal sheet exhibits a sufficient mechanical strength for various application areas of the proximity switch, which can be superior to an enclosure of corresponding dimensions which is directly formed by material removal from a spatially extended work piece. Moreover, it has been found that such an enclosure can be manufactured with a desired precision by the deep drawing and/or subsequent manufacturing steps in order to be functional to transmit the magnetic fields stemming from the periodic current pulses inside the enclosure and from the currents induced in the detected object outside the enclosure, in order to provide a desired detection reliability. In particular, an advantageous deformation of the metallic matrix of the non-ferromagnetic metal sheet during deep drawing can be exploited in order to result in an improved mechanical strength of the tubular element. For instance, an inductive proximity switch with a comparatively small outside diameter of 5 mm and below and with a sufficient mechanical strength is feasible by employing this manufacturing method.

Further advantageous features and preferred embodiments of the invention are described below and can be correspondingly applied to the proximity switch and to its manufacturing method.

In a preferred embodiment, the forming of the enclosure comprises the step of removing material from the front wall of the tubular element to provide the front wall with a predetermined thickness.

According to a first aspect, this step of material removal can be advantageous when irregularities in the wall thickness of the tubular element are caused during the step of deep drawing. In particular, a desired degree of precision or homogeneity of the front wall thickness may not be met after deep drawing which could negatively affect the measurement performance since the front wall comprises the active area of the switch and the electronic components therefore must be calibrated with respect to the thickness of the non-ferromagnetic material at the front wall. Thus, the step of removing material from the front wall can be exploited to provide a homogenous front wall thickness and to ensure a reliable measurement performance. It was found in the course of the present invention that the superior mechanical strength of the tubular element obtained by deep drawing can be substantially maintained after such a reworking process of material removal from the front wall.

According to a second aspect, the step of removing material from the front wall can also be advantageous to generally improve the robustness of the enclosure. In particular, a comparatively thick non-ferromagnetic metal sheet can be used during the deep drawing, providing a very robust tubular element due to its thick side wall on the one hand and due to the fabrication method via deep drawing on the other hand. Subsequently, the step of removing material from the front wall can be applied in order to reduce the front wall thickness comprising the active area of the switch to a desired thickness of the non-ferromagnetic material for which the electronic components are calibrated and/or functional in a reliable manner. Thus, the front wall preferably has a smaller thickness as compared to the side wall of the tubular element. It was found in the course of the present invention that the reduced thickness of the front wall may only have a negligible impact on the overall robustness of the enclosure.

Preferably, the front wall has a thickness of at most equal to, more preferred at most one half and most preferred at most one third, of the thickness of the side wall. In this way, a very robust enclosure can be provided by ensuring a proper functionality of the proximity switch. The cross section of a corresponding tubular element preferably has an inner diameter that is at most ten times larger as compared to the thickness of the side wall. Advantageously, such a dimension of the cross section can be applied to provide an inner space that is sufficient to accommodate the electronic components and a corresponding thickness of the side wall allowing a high protection of the electronic components.

According to a preferred embodiment of the enclosure, the thickness of the side wall is at least 0.1 mm, more preferred at least 0.2 mm. The thickness of the front wall is preferably at most 10 mm, more preferred at most 1 mm and most preferred at most 0.5 mm. The length of the tubular element is preferably at least 20 mm and/or at most 100 mm.

In the case of thickness variations of the side wall and/or front wall, the above mentioned parameter values of the thickness preferably refer to the respective maximum thickness in the middle third of the respective wall length. In the case that regular thickness variations or surface structures, for instance in the form of mounting structures, textures, slots, indentations or the like, are provided on the side wall and/or front wall, a wall position outside those surface structures is preferably referred to as the respective thickness having the above mentioned parameter values.

Preferably, the non-ferromagnetic material is removed from the front wall by cutting. An efficient cutting technique to obtain homogenous surface properties preferably comprises turning of the tubular element with respect to a lathe.

In some embodiments of the proximity switch, the fabrication method preferably comprises forming of a mounting structure on the outer surface of the tubular element. The mounting structure can be employed to interact with a corresponding surface structure provided on a desired mounting location for the enclosure, thus allowing an easy and robust installation of the proximity switch and avoiding additional prefabricated parts for device mounting. Preferably, the mounting structure comprises a thread which can provide a very stable connection with the mounting environment.

Preferably, the forming of the mounting structure comprises the step of removing material from the side wall of the tubular element. More preferred, the mounting structure is produced by a rolling process, in particular thread rolling. The process may comprise rolling of the tubular element with respect to at least one cutting roll or cutting die. Most preferred, a cold rolling process executed below the recrystallization temperature of the non-ferromagnetic metal is employed. Alternatively or additionally, a cutting process may be used. The forming process comprising rolling, however, can provide the advantage of an increased traction resistance and robustness of the produced mounting structure and the resulting tubular element. The reason for such a higher resistance lies in a deformation of the internal matrix composition of the non-ferromagnetic metal at the region of the mounting structure when a rolling process is employed.

In order to further improve the robustness of the enclosure, the non-ferromagnetic metal preferably consists of austenitic stainless steel. A particularly preferred material is constituted by a steel comprising chromium, nickel and molybdenum. Such a material composition can provide a high mechanical strength of the enclosure, wherein magnetic field-induced disturbance effects are kept sufficiently low. More preferred, the austenitic grade of the steel is AISI 316 or 316L (EN 1.4401, 4404, 4432, 4435 or 4436), also called V4A. It was found in the course of the present invention that an enclosure fabricated by deep drawing from this material, which is commonly known as V4A stainless steel, can withstand exceptionally harsh conditions. In contrast, it was found that this material is not well suited for a fabrication of the enclosure by means of a direct material removal from a spatially extended solid work piece which would lead to considerably more effort and could also result in inferior mechanical properties.

Preferably, the tubular element formed by deep drawing has an open back end through which the electronic components can be inserted. Before or during the insertion of the electronic components, a sheathing is preferably inserted inside the inner space of the tubular element by which the inner surface of its side wall and/or front wall is covered. The sheathing preferably comprises a synthetic material, for example an acrylonitrile-butadiene-styrene (ABS) resin, offering an additional protection for the electronic components. Furthermore, the sheathing preferably comprises a metallic material, typically brass, acting as a metallic shielding to eliminate parasitic inductions. Preferably, the open back end of the enclosure is covered after the insertion of the electronic components, in particular by applying an end cap at the open back end.

To optimize the deep drawing process for the fabrication of the enclosure, the sheet of the non-ferromagnetic metal is preferably disk shaped. In this way, the shape of the preformed blank can be assimilated to the shape of the enclosure as much as possible and material wastage is kept low. According to a specific example, in order to obtain an enclosure from the deep drawing process with desired dimensions combined with a desired mechanical strength, in particular with respect to the above described material composition, the diameter of the disk may be calculated according to the following formula:

$$D = \sqrt{(d + 2T_1) + 4L_1(d + 2T_1)} \; ,$$

wherein D refers to the diameter and $T_1$ to the thickness of the non-ferromagnetic metal disk, and d refers to the inner diameter and $L_1$ to the length of the enclosure fabricated from this non-ferromagnetic metal disk. According to the invention, an optimum diameter D of the non-ferromagnetic metal disk is preferably determined through this formula by a value of d ranging in between 3 mm and 30 mm, a value of $T_1$ ranging in between 0.7 mm and 0.9 mm and a value of $L_1$ ranging in between 10 mm and 80 mm. More generally, the thickness of the sheet of the non-ferromagnetic metal is preferably at least 0.1 mm and/or at most 10 mm, more preferred at least 0.2 mm and/or at most 3 mm.

The invention is explained in more detail hereinafter by means of preferred embodiments with reference to the drawings which illustrate further properties and advantages of the invention. The figures, the description, and the claims comprise numerous features in combination that one skilled in the art may also contemplate separately and use in further appropriate combinations. In the drawings:

Fig. 1    is a schematic meridian section through an inductive proximity switch;

Fig. 2    is a schematic representation of a non-ferromagnetic metal disk;

Fig. 3    is a schematic representation of a tubular element that has been obtained by deep-drawing of the metal disk shown in Fig. 2;

Fig. 4    is a schematic representation of a tubular element that has been obtained after a reworking process of the tubular element shown in Fig. 3;

Fig. 5    is a schematic representation of a tubular element that has been obtained after a reworking process of the tubular element shown in Fig. 4;

Fig. 6a   is a schematic sectional view of a mounting structure on the tubular element shown in Fig. 5 formed by rolling; and

Fig. 6b   is a schematic sectional view of a mounting structure on the tubular element shown in Fig. 5 formed by cutting.

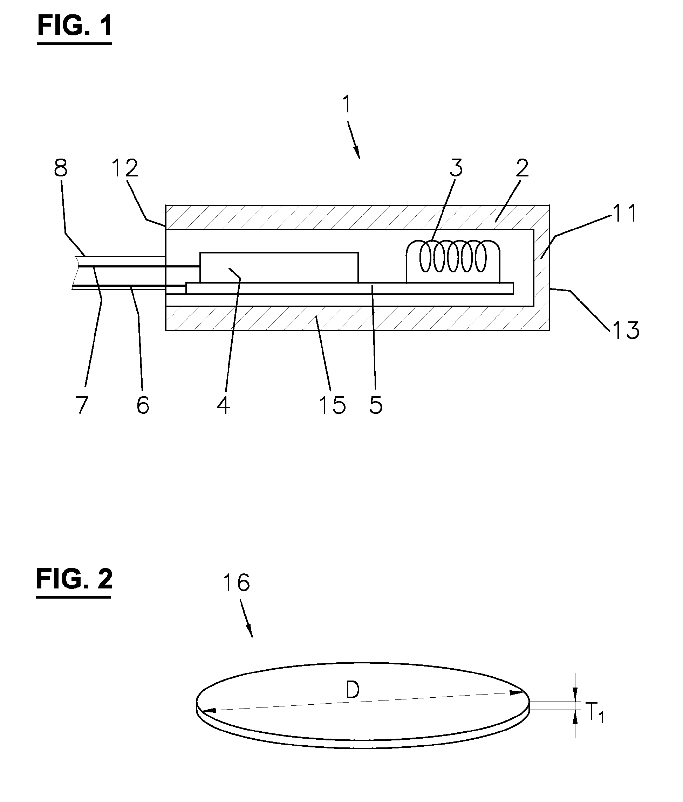

Fig. 1 schematically depicts an inductive proximity switch 1 comprising an enclosure 2 in which electronic components are included. The electronic components comprise a coil 3 arranged in a frontal part of enclosure 2 and a processing circuit 4 arranged behind coil 3. Coil 3 and processing circuit 4 are mounted on a conductor board 5 extending in the longitudinal direction of enclosure 2.

Electric conductors 6, 7 extend from conductor board 5 and processing circuit 4 to the outer region of enclosure 2, where they are embedded in a cable sheathing 8. Electric conductors 6 serve to supply coil 3 with transmitting current pulses at a period larger than the duration of the transmitting current pulses. Electric conductors 7 serve to transfer an output signal generated in processing circuit 4 based on received voltages induced in coil 3 after the duration of the transmitting current pulses. The functional principle of proximity switch 1 is described in greater detail in patent applications No. EP 0 936 739 A1 and EP 2 429 077 A1 which are herewith incorporated by reference.

The enclosure consists of a tubular element 2 formed from a single work piece and comprising a substantially cylindrical side wall 11 laterally enclosing electronic components 3, 4, 5, 6, 7. Tubular element 2 also comprises a front wall 11 neighboring coil 3 and covering the front end. The outer surface 13 of front wall 11 constitutes an active area of switch 1. A detection of a change of position of an object in the proximity of switch 1 is carried out with respect to active area 13. The thickness of front wall 11 is chosen with regard to an optimum operation of electronic components 3, 4, 5, 6, 7. Side wall 15 has a larger thickness as compared to front wall 11 to improve the robustness of enclosure 2 and the protection of the electronic components 3, 4, 5, 6, 7 contained therein.

Tubular element 2 further comprises an open rear end 12 through which electronic components 3, 4, 5, 6, 7 can be inserted during manufacturing of switch 1. After insertion of the components, rear end 12 of enclosure 2 is covered by a separate piece, preferably a closing cap, in which conductors 6, 7 pass through.

The material of enclosure 2 consists of a non-ferromagnetic metal with a relatively large specific resistance. The material choice largely prevents a generation of eddy currents in the enclosure walls, such that voltages induced in coil 3 stemming from parasitic eddy currents remain negligible with respect to voltages induced in coil 3 stemming from an object to be detected. Some other properties of enclosure 2 are described in greater detail in patent application No. EP 0 936 741 A1 which is herewith incorporated by reference.

A method of fabricating enclosure 2 employs a solid metal rod on which a cutting tool is applied from one end to progressively cut out the enclosure cavity. This method has the advantage that the enclosure can be fabricated in one basic processing step in which the desired precision with respect to the wall thickness of tubular element 2 can be met. For certain applications, however, an enclosure with an improved robustness is required, in particular when the dimensions of enclosure 2 are reduced.

A preferred method of fabricating enclosure 2 with an improved robustness is based on a non-ferromagnetic metal disk 16, as schematically indicated in Fig. 2. Disk 16 has a substantially circular shape with a preferred diameter D according to the formula given above.

It has been found that a material of disk 16 consisting of stainless steel with an austenitic grade as AISI 316 or 316L / EN 1.4401, 4404, 443, 4435, or 4436 (also known as V4A stainless steel) is particularly well suited to put this method into practice and to fabricate enclosure 2 with the combined advantages of an improved robustness and negligible disturbing ferromagnetic properties. The same material has been found to be less suited for an enclosure fabrication by means of direct cutting from a solid metal rod. In this case, a material of the metal rod consisting of stainless steel with an austenitic grade of 304 (also known as V2A stainless steel) is more suitable.

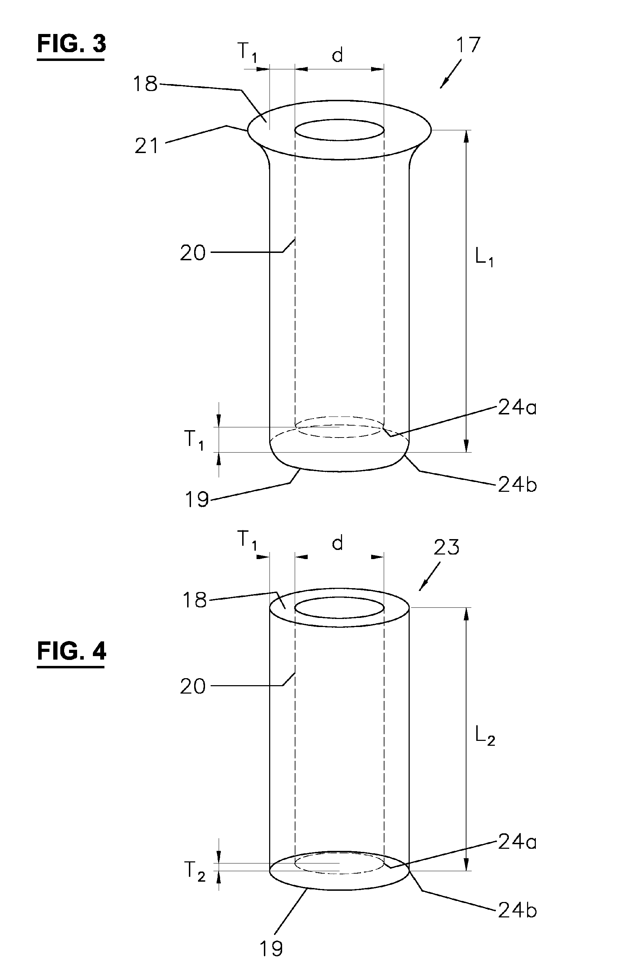

The preferred method comprises the step of deep drawing metal disk 16 to a tubular element 17, as shown in Fig. 3. Tubular element 17 is substantially cylindrical and has a covered front end 19 and an open rear end 18. Deep drawing is carried out in such a way that tubular element 17 is provided with a length L1 and an inner diameter d defining an inner space that is customized for the accommodation of electronic components 3, 4, 5, 6, 7. According to a specific example, length L1 ranges in between 20 mm to 50 mm and inner diameter d ranges in between 2 to 4 mm. According to another specific example, length L1 ranges in between 50 mm to 100 mm and inner diameter d ranges in between 15 mm to 50 mm. The wall thickness of front wall 19 and side wall 20 substantially corresponds to wall thickness T1 of disk 16.

Depending on the deep drawing process, a bordering edge 21 protruding around the circumference of open rear end 19 may be produced. Alternatively, a deep drawing process can be applied in which substantially no bordering edge is present at the rear end of tubular element 17. Moreover, surface inhomogeneities and/or irregularities of the wall thickness at the front part of tubular element 17 may be produced. In particular, a rounded shape at the inner edge 24a and/or the outer edge 24b of front wall 19 can be caused depending on the process of deep drawing.

According to one embodiment, tubular element 17 obtained from deep drawing of metal disk 16 can be directly applied in place of enclosure 2 of proximity switch 1 shown in Fig. 1. In this way, a more robust enclosure as compared to current enclosures can be achieved by an advantageous combination of the following provisions, each contributing on its own to an improved robustness: On the one hand, the austenitic steel material of disk 16 and/or the wall thickness T1 of disk 16 are selected to achieve a desired mechanical strength. On the other hand, the forming process of tubular element 17 itself starting from disk 16 yields a higher material strength due to an advantageous deformation of the metallic matrix during deep drawing.

According to another embodiment, tubular element 17 obtained from deep drawing of metal disk 16 constitutes a preformed blank that is reworked in one or more subsequent process steps. During those steps, the high mechanical strength of tubular element 17 is at least partly or substantially fully conserved. The reworking steps are carried out to obtain an advantageous enclosure for proximity switch 1 that is further adapted to the mode of operation of the internal electronic components 3, 4, 5, 6, 7 and/or specific needs of the measurement environment.

Fig. 4 depicts a tubular element 23 that has been obtained by reworking of blank 17 after deep drawing and can be used as enclosure 2 of proximity switch 1 shown in Fig. 1. In one reworking step, bordering edge 21 of blank 17 has been removed, in particular by a shortening of blank 17 with respect to its length L1 or by a circumferential removal of material. In another reworking step, front wall 19 of blank 17 has been thinned down to a thickness T2 which is adapted to the operational requirements of electronic components 3, 4, 5, 6, 7 to allow reliable object detection with respect to active area 13 of switch 1. According to a specific example, thickness T2 ranges in between 0.1 and 1 mm, for specific applications such as a high surrounding pressure in between 1 and 10 mm. To further improve the detection reliability, the rounded inner edge 24a of blank 17 has been reworked in a further step to a sharper form resulting in a more homogenous inner surface of front wall 19.

During the above described reworking steps, material is removed from blank 17 by cutting. Preferably, the cutting is carried out by turning of blank 17 with respect to a lathe. Despite the material removal from blank 17, it has been found that a high robustness of tubular element 23 can be maintained due to the advantageous material properties of blank 17. Further, machining time and generation of waste are strongly reduced.

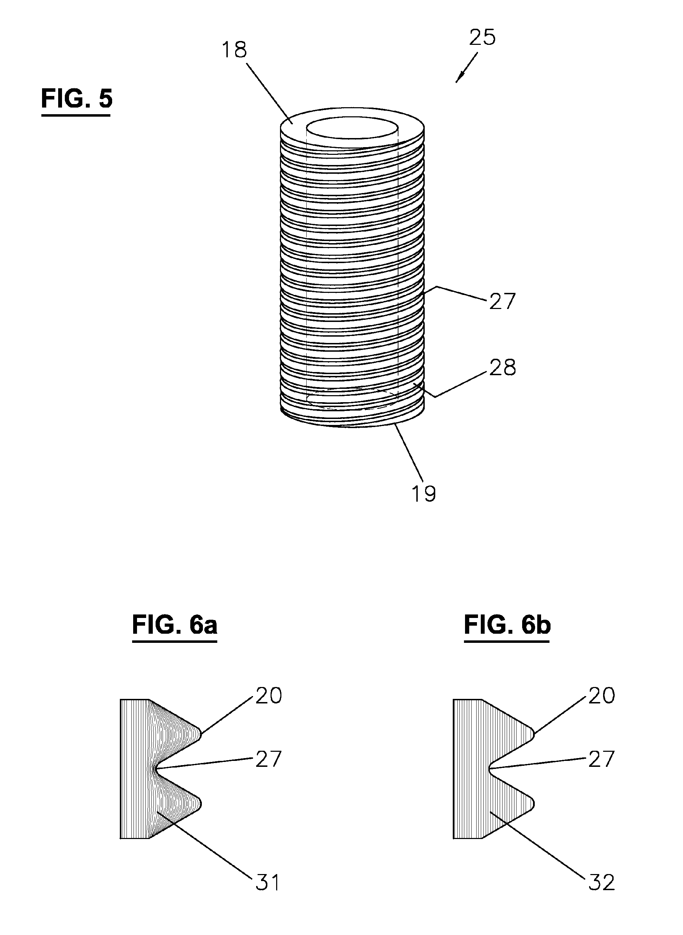

Fig. 5 depicts a tubular element 25 that has been obtained from tubular element 23 after a further reworking step and can also be used as enclosure 2 of proximity switch 1 shown in Fig. 1. On side wall 20 of tubular element 25, a mounting structure 27 is formed. Mounting structure 27 is a thread with a recessed helical course in the longitudinal direction of side wall 20. Thread 27 allows an advantageous mounting at desired application areas of proximity switch 1.

Mounting structure 27 is formed by material removal from the outer surface of side wall 20. Due to the advantageous material properties of blank 17, in particular due to the deep drawing process of disk 16 provided with an appropriate austenitic steel material and an appropriate wall thickness T1, a high robustness of tubular element 25 can be largely maintained after the forming of mounting structure 27. To further improve the mechanical stability of tubular element 25, mounting structure 27 is preferably produced by thread rolling, as indicated in Fig. 6a.

Figs. 6a and 6b depict a detailed sectional view of mounting structure 27 formed in side wall 20 of tubular element 25, each obtained by a different fabrication method. Mounting structure 27 shown in Fig. 6a has been fabricated by cold rolling. The rolling process leads to a deformation of the internal matrix composition 31 of the non-ferromagnetic metal. The deformation provides, similar to the deformation of the metal matrix induced by the deep drawing of sheet 16, to an improved mechanical strength. In contrast, mounting structure 27 shown in Fig. 6b has been fabricated by cutting. In this case, no deformation of the internal matrix composition 32 of the non-ferromagnetic metal and in consequence no further improvement of the mechanical stability of tubular element 25 as compared to blank 17 takes place.

Before tubular element 17, 23, 25 is used as an enclosure of proximity switch 1, sheathing is preferably inserted inside the inner space of the tubular element. The sheathing is formed by at least one sheet of a synthetic material, such as an acrylonitrile-butadiene-styrene (ABS) resin, offering an additional protection for electronic components 3, 4, 5, 6, 7. Moreover, the sheathing preferably comprises at least one sheet of brass or a similar metallic material acting as a shielding for electromagnetic perturbations.

In a final step, electronic components 3, 4, 5, 6, 7 of switch 1 as shown in Fig. 1 are inserted into tubular element 17, 23, 25 in the place of enclosure 2 and open rear end 18 is then covered by a closing cap.

From the foregoing description, numerous modifications of the inductive proximity switch according to the invention and to its manufacturing method are apparent to one skilled in the art without leaving the scope of protection of the invention that is solely defined by the claims.

## Claims

1. A method of manufacturing an inductive proximity switch, in which an enclosure (2) is formed from a single piece (16) of a non-ferromagnetic metal and electronic components (3, 4, 5, 6, 7) are inserted into the enclosure (2), the electronic components comprising a coil (3) configured to be supplied with transmitting current pulses at a period larger than the duration of the transmitting current pulses and a processing circuit (4) configured to generate an output signal based on received voltages induced in the coil (3) after the duration of the transmitting current pulses, **characterized in that** said forming of the enclosure comprises the step of deep drawing a sheet (16) of the non-ferromagnetic metal to a tubular element (2, 17, 23, 25) with a front wall (11, 19) covering its front end and a side wall (15, 20) delimiting an inner space for receiving the electronic components (3, 4, 5, 6, 7).

2. The method according to claim 1, **characterized in that** said forming of the enclosure (2) comprises the step of removing material from the front wall (11, 19) to provide the front wall (11, 19) with a predetermined thickness.

3. The method according to claim 2, **characterized in that** said removing of material from the front wall (11, 19) comprises turning of the tubular element (2, 17, 23, 25) with respect to a lathe.

4. The method according to at least one of the claims 1 to 3, **characterized in that** said forming of the enclosure (2) comprises the step of removing material from the side wall (15, 20) to provide a mounting structure (27) on its outer surface.

5. The method according to claim 4, **characterized in that** said removing of material from the side wall (15, 20) comprises a rolling process, in particular thread rolling.

6. The method according to at least one of the claims 1 to 5, **characterized in that** the non-ferromagnetic metal is austenitic stainless steel.

7. The method according to claim 6, **characterized in that** the steel comprises chromium, nickel and molybdenum.

8. The method according to claim 6 or 7, **characterized in that** the austenitic grade of the steel is AISI 316 or 316L.

9. The method according to at least one of the claims 1 to 8, **characterized in that** the tubular element (2, 17, 23, 25) formed by deep drawing comprises an open back end (12, 18) through which the electronic components (3, 4, 5, 6, 7) are inserted.

10. An inductive proximity switch comprising an enclosure (2) formed from a single piece (16) of a non-ferromagnetic metal and electronic components (3, 4, 5, 6, 7) that are inserted into the enclosure (2), the electronic components comprising a coil (3) configured to be supplied with transmitting current pulses at a period larger than the duration of the transmitting current pulses and a processing circuit (4) configured to generate an output signal based on received voltages induced in the coil (3) after the duration of the transmitting current pulses, **characterized in that** the enclosure consists of a tubular element (2, 17, 23, 25) that is deep drawn from a sheet (16) of the non-ferromagnetic metal such that a front wall (11, 19) covering its front end and a side wall (15, 20) delimiting an inner space for receiving the electronic components (3, 4, 5, 6, 7) is provided.

11. The inductive proximity according to claim 10, **characterized in that** the front wall (11, 19) has an equal or smaller thickness as compared to the side wall (15, 20) of the tubular element (2, 17, 23, 25).

12. The inductive proximity according to claim 11, **characterized in that** the front wall (11, 19) has a thickness of at most equal to, more preferred at most one third of, the thickness of the side wall (15, 20).

## FIG. 1

## FIG. 2

**FIG. 3**

17

18

21

$T_1$

d

20

$L_1$

$T_1$

24a

19

24b

**FIG. 4**

$T_1$

d

23

18

20

$L_2$

$T_2$

24a

19

24b

**FIG. 5**

**FIG. 6a**

**FIG. 6b**

10

Europäisches
Patentamt

European
Patent Office

Office européen
des brevets

**EUROPEAN SEARCH REPORT**

Application Number

EP 12 18 2879

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | EP 0 936 741 A1 (OPTOSYS AG [CH]) 18 August 1999 (1999-08-18) * the whole document * ----- | 1-12 | INV. H03K17/95 G01D11/24 |
| A | US 2009/107393 A1 (ROSS JR HERBERT G [US]) 30 April 2009 (2009-04-30) * the whole document * * paragraph [0034] - paragraph [0035]; figures 6-8 * ----- | 1-12 | |
| A | DE 10 2006 060648 A1 (WABCO GMBH [DE]) 26 June 2008 (2008-06-26) * paragraph [0022]; figure 2 * ----- | 1 | |
| A | EP 0 626 565 A1 (WABCO VERMOEGENSVERWALTUNG [DE] WABCO GMBH [DE]) 30 November 1994 (1994-11-30) * column 2, line 32 - line 51; figure 1 * ----- | 1 | |
| A | WO 2012/079838 A1 (BOSCH GMBH ROBERT [DE]; KROECKEL MARKUS [DE]) 21 June 2012 (2012-06-21) * page 4, line 32 - page 5, line 14 * ----- | 1 | TECHNICAL FIELDS SEARCHED (IPC) H03K G01D H05K B21D |
| A | US 4 196 467 A (JAKOB GERT [DE] ET AL) 1 April 1980 (1980-04-01) * column 1, line 37 - line 40; figure * ----- | 1 | |

The present search report has been drawn up for all claims

| Place of search | Date of completion of the search | Examiner |
|---|---|---|
| The Hague | 31 January 2013 | Jepsen, John |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 12 18 2879

This annex lists the patent family members relating to the patent documents cited in the above-mentioned European search report.
The members are as contained in the European Patent Office EDP file on
The European Patent Office is in no way liable for these particulars which are merely given for the purpose of information.

31-01-2013

| Patent document cited in search report | | Publication date | Patent family member(s) | | Publication date |
|---|---|---|---|---|---|
| EP 0936741 | A1 | 18-08-1999 | NONE | | |
| US 2009107393 | A1 | 30-04-2009 | NONE | | |
| DE 102006060648 | A1 | 26-06-2008 | CN 101542239 A | | 23-09-2009 |
| | | | DE 102006060648 A1 | | 26-06-2008 |
| | | | EP 2104836 A1 | | 30-09-2009 |
| | | | US 2010064788 A1 | | 18-03-2010 |
| | | | WO 2008083785 A1 | | 17-07-2008 |
| EP 0626565 | A1 | 30-11-1994 | DE 4317848 A1 | | 01-12-1994 |
| | | | EP 0626565 A1 | | 30-11-1994 |
| | | | JP 7072160 A | | 17-03-1995 |
| WO 2012079838 | A1 | 21-06-2012 | DE 102010063158 A1 | | 21-06-2012 |
| | | | WO 2012079838 A1 | | 21-06-2012 |
| US 4196467 | A | 01-04-1980 | DE 7709621 U1 | | 07-07-1977 |
| | | | JP 53120195 A | | 20-10-1978 |
| | | | US 4196467 A | | 01-04-1980 |

EPO FORM P0459

For more details about this annex : see Official Journal of the European Patent Office, No. 12/82

## REFERENCES CITED IN THE DESCRIPTION

**Patent documents cited in the description**

- EP 0936739 A1
- EP 0936741 A1

- EP 2429077 A1